# EUROPEAN PATENT SPECIFICATION

(11) **EP 0 409 409 B1**
(45) Date of publication and mention of the grant of the patent: **31.05.1995**
(21) Application number: 90306714.8
(22) Date of filing: 20.06.1990
(51) Int. Cl.: H01L 39/12, H01L 39/24

(54) **Superconducting materials**
Supraleitende Materialien
Matériaux supraconducteurs

(30) Priority: 19.07.1989 US 382452
(43) Date of publication of application: 23.01.1991
(73) Proprietor: FORD MOTOR COMPANY LIMITED, Brentwood, Essex CM13 3BW (GB); FORD FRANCE S. A., 92506 Rueil-Malmaison Cédex (FR); FORD-WERKE AKTIENGESELLSCHAFT, 50725 Köln (DE)
(72) Inventor: Wenger, Lowell E., Troy, Michigan 48098 (US); Chen, Juei-Teng, Sterling Heights, Michigan 48310 (US); Logothetis, Eleftherios M., Birmingham, Michigan 48009 (US)
(74) Representative: Messulam, Alec Moses

(56) References cited:
- ELECTRONIC ENGINEERING, vol. 60, no. 741, September 1988, page 25, Woolwich,GB; J. EVETTS et al.: "High Tc superconductors at Cambridge"
- SCIENCE, vol. 246, 20th October 1989, page 320, Washington, US; R. POOL et al.:"Zero resistance at 250 K?"
- CHEMICAL ENGINEERING, 16th October 1989, pages 26-27, New York, US; R. DAGANIet al.: "Superconductivity signs above 200K"
- OYO BUTURI, Vol. 57, No. 2, 10th Feb. 1988, pp. 221 - 226, T. Hirao et al. and CHEMICAL ABSTRACTS, Vol. 109, No. 26, 26th Dec. 1988, accession no. 241983x, Columbus, Ohio, US

## Description

This invention relates to a method for making copper oxide based materials having a zero resistance transition temperature (T_{c}) above about 200 K. This invention further relates to a method for maintaining the zero resistance property of these copper oxide based materials.

The recent discovery of superconducting metal oxides such as YBa₂Cu₃O_{7-y} (with y < 0.5) having superconducting transition temperatures at least 10 to 20 K above the temperature of liquid nitrogen (77 K) has created a great deal of excitement. As known in the art, the superconducting transition temperature (T_{sc}) of a material is that temperature below which the material has essentially zero electrical resistance. Heretofore known superconducting materials have much lower T_{sc}'s. These superconducting metal oxides have vast potential for use in diverse applications in a large number of electrical and electronic devices which can operate at these higher temperatures. This material is discussed by T. Hirao et al. in "Oyo Butari", Vol. 57, 1988, pp. 221-226.

Generally, in making such superconducting materials in the Y₁Ba₂Cu₃O_{7-δ} system, a metal oxide precursor material is first formed and then subjected to an anneal in oxygen to make it superconducting. The typical annealing schedule consists of a relatively slow heating to a peak temperature in the range of 850 to 950°C, annealing in oxygen at this temperature for a time period ranging from a few minutes to several days, followed by a slow cooling at a rate of 1 to 3 degrees per minute in O₂. It is believed that oxygen atoms diffuse into the lattice structure when the material cools down through the temperature range of about 600-450°C. These materials, having transition temperatures around 90 K, are stable at room temperature in air and retain their superconducting properties (transition temperatures around 90 K) even through repeated thermal cycling between 4 K and 300 K. This is believed due to the fact that the oxygen is "locked" in the crystal lattice.

A great deal of effort has been expended in the last 24 months to make superconducting materials having even higher transition temperatures than those described above. Currently, the highest superconducting transition temperature for well established CuO-based materials is 125 K in the TlBaCaCuO system, although evidence for superconductivity/zero resistance at temperatures above this temperature in CuO-based materials has been reported in numerous publications and communications since February 1987, including the following papers: J. T. Chen, L. E. Wenger, C. J. McEwan, and E. M. Logothetis, "Observation of the reverse ac Josephson effect in YBaCuO at 240K", Physical Review Letters, Vol. 58, No. 19, pp. 1972-1975, 11 May 1987; C. Y. Huang, L. J. Dries, P. H. Hor, R. L. Meng, C. W. Chu, and R. B. Frankel, "Observation of possible superconductivity at 230 K", Nature, Vol. 328, pp. 403-404, 30 July 1987; H. Ihara, N. Terada, M. Jo, M. Hirabayashi, M. Tokumoto, Y. Kimura, T. Matsubara, and R. Sugise, "Possibility of superconductivity at 65°C in SrBaYCuO system", Japanese Journal of Applied Physics, Vol. 26, pp. L1413-L415, 1987; J. Narayan, V. N. Shukla, S. J. Lukasiewicz, N. Biunno, R. Singh, A. F. Schreiner, and S. J. Pennycook, "Microstructure and properties of Y₁Ba₂Cu₃O_{9-w} superconductors with transitions at 90 and 290 K", Applied Physics Letters, Vol. 51, No. 12, pp. 940-942, 21 September 1987; and H. D. Jostarndt, M. Galffy, A. Freimuth, and D. Wohlleben, "Unstable high temperature superconductivity and martensitic effects in YBaCuO", Solid State Communications, Vol. 69, No. 9, pp. 911-913, March 1989. These papers teach that although previous materials showing higher transition temperatures (greater than 90 K) were prepared by conventional ceramic techniques, the materials all suffer from the lack of stability and reproducibility. That is, the zero-resistance state (the ability to pass current without any voltage drop or power loss) in these CuO-based superconducting materials at these higher transition temperatures is a temporary (usually one time) phenomenon which may exist for only a few thermal cyclings of the sample through its higher transition temperature, even though the lower 90 K superconducting transition remains.

In addition, several papers report that exposure of certain CuO-based superconductors to a gas during electrical measurements at cryogenic temperatures (77 K to 150 K) can enhance their 90 K superconducting transition temperature. These Papers include: D. N. Matthews, A. Bailey, R. A. Vaile, G. J. Russell, and K. N. R. Taylor, "Increased transition temperature in Y₁Ba₂Cu₃O_{y} superconducting ceramics by exposure to nitrogen", Nature, Vol. 328, pp. 786-787, 27 August 1987; K. N. R. Taylor, A. Bailey, D. N. Matthews, and G. J. Russell, "Enhancement of T_{c} in Y₁Ba₂Cu₃O_{7-w} superconductors by gas absorption", Physica C, Vol. 153-155, pp. 349-350, 1988; D. N. Matthews, A. Bailey, T. Puzzer, G. J. Russell, J. Cochrane, R. A. Vaile, H. B. Sun, and K. N. R. Taylor, "Effects of helium absorption on the superconducting mechanism of Y₁Ba₂Cu₃O_{y}", Solid State Communications, Vol. 65, No. 5, pp. 347-350, February 1988; and X. Granados, M. Carrera, J. Fontcuberta, M. Vallet, and J. M. Gonzalez-Calbet, "On the effects of helium absorption on the superconducting onset of Y₁Ba₂Cu₃O_{7-y}", Solid State Communications, Vol. 69, No. 11, pp. 1073-1077, March 1989. The cited reference in Physica C teaches that the superconducting transition temperature for a single-phase Y₁Ba₂Cu₃O₇ superconductor material can be enhanced to a maximum of 105 K when exposed to O₂ gas for a few hours at 77 K, although the zero resistance state still occurs at 90k.

Extensive research has been carried out in an attempt to provide a "stable", higher transition temperature superconducting phase material because of its potential for applications in the electronic/electrical industries.

It is an object of the present invention to provide a method for making a material that exhibits a zero resistance state at a temperature above the temperature of dry ice (195 K) and for maintaining this zero resistance state substantially stable even through repeated thermal cycling.

We have found that such a state is exhibited by an oxygenated multiphase, i.e. mixed-structural-phase, copper oxide based material that has a specific composition and has been made by calcination and low temperature oxygenation of a corresponding precursor, and that the state may be maintained by maintaining the oxygen content of the oxygenated material.

According to the invention a method for making a copper oxide based material having a zero resistance transition temperature above 200 K comprises forming an oxygenated multiphase copper oxide based material having the nominal composition Y₅Ba₆Cu₁₁0_{y} by calcining a corresponding precursor material and then subjecting it to a low temperature oxygenation in an atmosphere comprising at least 50% of oxygen by volume at a temperature less than 200°C. The invention includes the oxygenated multiphase copper oxide based material having a zero resistance transition temperature above 200 K made in this way.

Loss of oxygen from a material made in this way may be prevented, and thus its zero resistance property may be maintained, by enveloping the material with a coating substantially non-permeable to oxygen or providing an oxygen atmosphere comprising at least 50% by volume oxygen surrounding the material while keeping the material at a temperature less than about 200°C.

The invention will now be described further, by way of example, with reference to the accompanying drawings, in which:
Figure 1 is a graph which shows the temperature dependence of the resistance for a Y₅Ba₆Cu₁₁0_{y} material made according to the invention;
Figure 2 is a graph which shows the current-voltage characteristics for the Y₅Ba₆Cu₁₁0_{y} material of Figure 1 in the temperature range below and above the transition temperature for zero-resistance; and
Figure 3 is a graph which shows the temperature dependence of the zero-field-cooled (zfc) and field-cooled (fc) magnetisation for the Y₅Ba₆Cu₁₁0_{y} material of Figure 1.

As indicated above, this invention, according to one aspect, is directed to a method of making a copper oxide based material exhibiting essentially zero electrical resistance above about 200 K.

The method comprises forming a copper oxide based material precursor, which precursor can be oxygenated (as described herein) to yield the copper oxide based material. The precursor may be in bulk, ceramic, single crystal or thin film form. The copper oxide material precursor according to the invention disclosed herein consists essentially of Y, Ba, Cu and o and has the nominal composition Y₅Ba₆Cu₁₁0_{y}.

The precursor, prior to being subjected to the oxygenation step, may be in bulk form. Bulk precursor samples may be prepared by any suitable technique, including conventional ceramic forming techniques which are well known in the art. According to conventional ceramic techniques, a precursor sample could be prepared by mixing appropriate starting materials (e.g., oxides, carbonates, hydroxides) in a ball mill. It may be desirable to subsequently press the mixture into a pellet at high pressures, e.g. 34.5-103.5 MPa (5000-15,000 psi), and then sintered the pellet under flowing oxygen at elevated temperatures, e.g., between 800-1000°C. Alternatively, according to conventional techniques, samples may be formed by first reacting the appropriate starting material powders at elevated temperatures under flowing oxygen, then regrinding the product to make a powder, and subsequently pressing the powder into pellets for final firing to form the precursor.

For example, precursor bulk materials of the nominal composition Y₅Ba₆Cu₁₁O_{y} were synthesised from Y₂O₃, BaCO₃, and CuO powders. The unreacted powders were calcined at about 925°C for 10 hours until becoming black, then ground into a powder and pressed into a pellet at about 345 MPa (50,000 psi). The pellet was sintered at 900°C for 24 hours in flowing O₂ and then reground. After pressing into another pellet, this pellet was sintered in O₂ at 925°C for another 24 hours to form the precursor. This invention is not meant to be limited, however, to such techniques or starting materials for the precursor according to this invention. Still other techniques and materials for forming bulk precursor materials according to this invention will be apparent to those skilled in the art in view of the present disclosure.

The precursor, prior to being subjected to the oxygenation step, may also be a film which has been applied to a substrate. The film may be deposited on any suitable substrate, that is one which will accept a film of the precursor and which can be subsequently oxygenated in an oxygen atmosphere according to this invention. Exemplary of substrates which can be herein employed for the method of the invention are SrTiO₃, LaAlO₃, LaGdO₃, ZrO₂, MgO, Al₂O₃, Si and SiO₂. The substrate may be of any type of such material and in any desired shape. If the film/substrate is intended for use in electronic devices, however, the substrate would probably be in the form of a wafer as is commonly used in the electronics industry.

The precursor film may be deposited on the substrate by any suitable deposition technique, many of which are well known in the art. The film may be deposited by physical deposition techniques including electron beam evaporation, sputtering, molecular beam epitaxy, ion beam deposition, laser deposition and by chemical deposition techniques, e.g., metalorganic deposition. According to such physical deposition techniques, the precursor may be deposited from a target or targets in a gas atmosphere or in a vacuum wherein the target comprises one of the component materials of the film or a composite of the components of the film. The targets may be in powder or compacted form. If the target comprises a composite of the components of the film, they may be reacted or unreacted. The precursor film may be deposited by techniques including electron beam evaporation employing sources of Cu metal, Y metal, and pressed BaF₂ with a subsequent 800-900°C oxygen anneal/calcination treatment to form the precursor film. As would be apparent to those skilled in the art in view of the present disclosure, other materials such as BaO₂, CuO₂, BaO, acetates of Y, Ba, Cu, etc, may be used in making the film. Still other suitable materials and techniques for making a precursor film will be apparent to those skilled in the art in view of the present disclosure.

As discussed above, we have found that if we subject the precursor to a low temperature oxygenation process, the precursor converts, after oxygenation, to a material having a zero resistance transition temperature above about 200 K, which T_{c} may be essentially maintained through repeated thermal cycling. This oxygenation process comprises subjecting the precursor (i) to an atmosphere comprising more than about 50% oxygen by volume, (ii) at a temperature less than about 200°C, preferably between about -100°C and 200C, most preferably between about 25°C and about 200°C, (iii) for a time sufficient to form the copper oxide based material. The oxygen atmosphere preferably comprises greater than 95% by volume oxygen. The remaining gases, if any, present in the oxygen atmosphere may be any gas or a mixture of gases which do not interfere with the oxygenation process. Such gas can include inert gases like nitrogen and argon. The oxygen atmosphere is preferably at least 0.1 mPa (one atmosphere) of pressure, more preferably at a pressure of greater than 10 mPa (100 atmospheres). For example, according to certain embodiments of the invention, oxygenation was carried out at a temperature between about 50-70°C in an atmosphere comprising more than about 95% oxygen for greater than about 5 days. According to other embodiments of the invention, oxygenation was carried out at a temperature between about 120-170°C in the oxygen atmosphere of 13 mPa (130 atmospheres) for at least about 72 hours. The optimal oxygenation processing conditions, e.g., the oxygenation time, the composition of the oxygen atmosphere, the temperature and pressure conditions, would be dependent, on the particular composition of the precursor, its porosity, the thickness of the precursor, etc., as will be apparent to one skilled in the art in view of the present disclosure. The oxygenated material may be cooled to room temperature if desired. If this is done, however, an oxygen environment preferably greater than 50% by volume, more preferably greater than 95% oxygen by volume, must be maintained surrounding the material in order to maintain the zero resistance property.

We have found that to maintain the zero resistance property of the oxygenating material once it has been produced it is necessary to essentially maintain its oxygen content.

This may be achieved in any of several different ways. For example, the oxygen content of the material may be maintained by enveloping it with a coating substantially non-permeable to oxygen. Such a coating may be a gas impervious ceramic oxide like aluminium oxide. Another way to essentially maintain the oxygen content of the material, and hence its properties, is to surround it with an oxygen environment which precludes a loss in the overall oxygen content of the material. This may comprise (i) providing an oxygen atmosphere comprising at least 50% by volume oxygen surrounding the copper oxide based material (essentially at all times), and (ii) keeping the temperature of the material at less than about 200°C. Under such conditions, even if some oxygen is diffusing out of the material, at the same time oxygen is being absorbed into the material, so that an equilibrium is established which maintains the overall oxygen content of the material. The pressure of the oxygen atmosphere may be varied so as to maintain this equilibrium. Preferably, the oxygen atmosphere comprises at least 95% by volume oxygen, and the temperature of the material is preferably less than about 100°C when the oxygen pressure is about one atmosphere. If the temperature is higher than 100°C, preferably the oxygen pressure is greater than about 0.1 mPa (one atmosphere), preferably greater than about 1 mPa (10 atmospheres). Selection of optimal conditions of pressure, temperature and amount of oxygen in the atmosphere will be apparent to those skilled in the art in view of the present disclosure. It has been found, that in order to maintain the zero resistance properties of the materials, e.g., even when making measurements of the electrical resistivity of the material, it is necessary to maintain the oxygen content of the material which may be done by keeping the material in an oxygen environment.

The invention will be further understood by referring to the following detailed examples. It should be understood that the subject examples are presented by way of illustration and not by way of limitation.

### Example 1

An oxygenated multiphase copper oxide based material was made according to an embodiment of this invention in this example. The precursor had a nominal composition of Y₅Ba₆Cu₁₁O_{y} and was synthesised by conventional ceramic techniques from Y₂O₃, BaCO₃, and CuO powders as follows. The unreacted powders were calcined at 925°C (±25°C) for 10 hours in air. This calcination step followed by subsequent grindings of the powder was repeated until a material with dark black colour and a fine crystallite texture was obtained. The reacted black powder is then pressed into a 1.9 cm (3/4 inch) disk-shaped pellet at approximately 345 mPa (50,000 psi). The pellet was sintered at 900°C for 24 hours in flowing O₂, cooled to room temperature over a period of 6 hours, and then reground. This powder was then heated to 925° for 24 hours in air, cooled to room temperature over a period of 6 hours, and reground. After pressing into another pellet, this pellet was sintered again in O₂ at 900°C for another 24 hours and then cooled to room temperature over a six hour period. The x-ray diffraction patterns of the sample indicated that this sample mainly consisted of the Y₁Ba₂Cu₃O_{7-y} phase, the Y₂BaCuO₅ phase, and the CuO phase. The sample appeared to contain a significant degree of (001) orientation in the Y₁Ba₂Cu₃O_{7-y} phase.

The pellet was subsequently cut into several small bar-shaped pieces of approximately 2 mm x 1 mm x 1 mm dimensions and placed inside a glass desiccator with an oxygen partial pressure of one atmosphere of oxygen. An oxygenation of the samples in the glass desiccator was carried out by continuously maintaining the samples in the desiccator at a temperature between about 50°C and 70°C by using an infrared heating lamp. TGA (thermal gravimetric analysis) measurements on other samples had indicated a weight increase up to 0.2% evidencing oxygenation thereof.

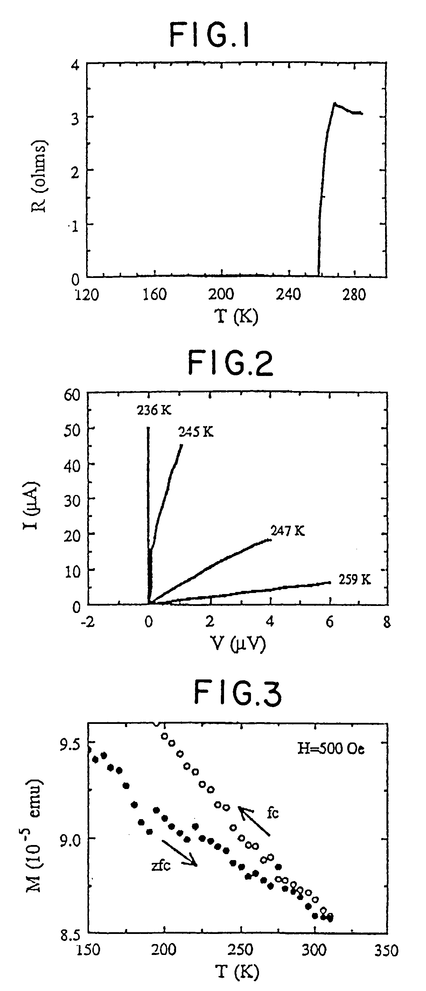

Measurements of the electrical resistance (two-probe, three-probe and four-probe arrangements) for one of five Y₅Ba₆Cu₁₁O_{y} samples from the desiccator (O₂ anneal at 70°C over a period of one week) resulted in the disappearance of any measurable voltage (less than 20 nanovolts) in the temperature range of 220 K to 260 K depending upon the bias current used and the direction in which the current flowed. For current flowing in the direction perpendicular to the applied force used in pressing the pellets, the first four-probe resistance measurement showed sharp resistance changes at approximately 90 K, 185 K, 225 K, 235 K, and 255 K when a dc current of 5 mA was applied. These resistive changes are strong indications that several possible superconducting phases are present in this sample. The resistive behaviour of the sample was studied by repeated cooling and warming (thermal cycling) of the sample between 300 K and 120 K. By the fifth thermal cycling, zero resistance for a dc current of 10 mA (current parallel to applied force during pressing the pellet) is evidenced at a temperature of 255 K (±5 K). Fig. 1 shows the temperature dependence of the resistance during the eighth thermal cycling. Note, in particular, the resistance drops to zero at 255 K. To reduce the effects of any possible thermal emfs, an ac resistance measurement using a 9.3 mAₚₑₐₖ₋ₚₑₐₖ, 7 millihertz ac current was utilized. The ac voltage disappeared also at 255 K (±5K). To determine the effect of the electrical lead arrangement, the four electrical lead arrangement was varied and still showed zero resistance below 255 K as long as the two current leads were on opposite sides of the sample. Additional two- and three-lead arrangements for the resistance measurements indicated that the resistive drops in the 240 K to 275 K temperature range resulted from the sample and not from some unusual equipotential lines due to the four electrical lead arrangement. To ensure the accuracy of the transition temperature determination, resistance measurements were also performed in a mixture of dry ice and acetone as the coolant still maintaining the O₂ environment around the sample. This procedure guarantees that the temperature is always above 200 K.

The zero-resistance state was further verified by performing current-voltage (I-V) characteristics measurements as a function of the temperature with the onset of a zero-voltage current of a few microamperes developing at the transition temperature. As seen in Fig. 2, the I-V characteristics at 259 K and above, obey Ohm's Law (a linear relationship between the current and the voltage). But in the transition region, for example at 245 K, the I-V curve shows a nonlinear behaviour with a small zero-voltage current of 14 mA. At 236 K, a sizeable zero-voltage current of 45 mA is clearly observable. This indicates that the sample's resistance was zero within the experimental resolution of 0.44 milliohm (20nV/45 mA), which is four orders of magnitude smaller than the normal state resistance at 280 K. This measurement was done after the twelfth (12th) thermal cycling which resistively indicated that the transition temperature for zero resistance to be 245 K. The difference of 10 K (.4%T_{c}) in the zero resistance transition temperatures described in Figures 1 and 2 is primarily due to the uncertainty in the temperature between the two different thermal cyclings.

As a function of the magnetic field, changes in the I-V characteristics very near the transition temperature were also observed in fields as small as 2 Oe. The influence of the magnetic field upon the I-V characteristics provides additional support for the zero resistance nature of the resistance transition. The stability of a 245 K zero-resistance state in this sample was observed to remain for numerous (29) thermal cyclings through the transition temperature (typical thermal cycling between 150-180 K to 300 K) over a period of 11 days. Magnetisation measurements on another sample from the same batch as well as from a smaller section of the sample showing zero resistance were also performed to see if diamagnetic contributions associated with superconductivity (the Meissner effect) could be detected. These magnetisation-versus-temperature curves showed diamagnetic-like deviations from their paramagnetic background in the temperature range of 220 K to 270 K depending upon the applied magnetic field and thermal cycling history. In Fig. 3, a thermal history dependent behaviour was evidenced in the magnetisation data taken after cooling the sample in zero magnetic field to about 150 K, then applying a field of 500 Oe, and measuring the magnetisation while warming the sample. Below 270 K, this so-called zero-field-cooled magnetisation data showed a significant difference from the field-cooled magnetisation data which is taken during cooling the sample from 310 K to 150 K in a field of 500 Oe. (It should be noted that the sample was surrounded by an oxygen atmosphere in these magnetisation measurements, too.) The sharp increase in the zero-field-cooled magnetisation at 275 K and resulting hystereric behaviour below 275 K provide further evidence for a weak diamagnetic response on top of a stronger paramagnetic background. The strong temperature correlations of these magnetic data to the electrical resistance results provide collaborative evidence for the onset of superconductivity in these samples at temperatures above 200 K.

It should be noted that the samples were kept in the heated O₂ atmosphere of the desiccator and were removed from this environment only when measurements were to be made at lower temperatures. In addition to the storage of the samples in an oxygen environment, experimental measurements of the electrical resistance and magnetisation of the samples below room temperature require the measuring environment to be an oxygen atmosphere in order to observe and to maintain the zero resistance properties above 200 K. It was found that to maintain the properties as described above, it was necessary to maintain the oxygen content of the material. The use of an oxygen atmosphere surrounding the samples during the taking of measurements below room temperature not only appears to prevent the degradation of the zero resistance superconducting property, but even appeared to improve this property after two or three thermal cyclings between 150 K and 300 K.

### Example 2

In this example, a copper oxide based material was made according to this invention. Y₅Ba₆Cu₁₁O_{y} samples were first prepared according to a similar procedure as Example 1. Specifically, the procedure was to calcine the unreacted powders at 925°C for 24 hours in air. This calcination step was followed by a grinding of the powder and another calcination (heating) at 950°C for another 24 hours in an O₂ atmosphere. The powder was reground, pressed into a pellet at about 345 mPa (50,000 psi), and sintered at 925°C for 10 hours in O₂.

Subsequently, this batch of samples was placed in a high pressure "vessel" filled with (pure) oxygen to a pressure of 13 mPa (130 atmospheres) for the oxygenation process. After an oxygenation in the oxygen for 96 hours at 150°C and cooling back to room temperature over a period of several hours, these samples were removed from the vessel and placed inside an oxygen-filled desiccator under the conditions of that of Example 1.

Qualitative and quantitative results similar to those described above for the zero resistance sample of Example 1 were observed from electrical resistance and magnetisation measurements made on one of the high pressure oxygenated samples of this example. This sample lost its electrical resistance at 265 K and has a zero-voltage current exceeding 4 milliamps at 240 K. This zero-voltage current was two orders of magnitude greater than that of the samples described in Example 1. Current-voltage measurements were made (current parallel to direction of applied force associated with pressing of pellet) for one of these Y₅Ba₆Cu₁₁O_{y} samples as a function of the temperature. An ohmic behaviour was observed for temperatures above 265 K indicating a resistive behaviour; however at 265 K, a nonlinear behaviour was displayed with an approximate 49 mA, zero-voltage current. At 258 K, no detectable voltage down to the limit of 10 nanovolts was seen at currents as high as 80 mA (resistance less than 10⁻⁴ ohms). At even lower temperatures, the zero-voltage current was still larger exceeding 4 mA at 240 K. A four-probe resistance measurement was taken 5 days later and showed a large resistance drop occurring at 295 K and zero resistance at 265 K, in agreement with the I-V measurements. Similar magnetisation behaviour as seen in Example 1 was also observed, namely, diamagnetic-like deviations and hystereric behaviour occurring at temperatures correlating to the resistance drops.

### Example 3

In this example, a zero resistance copper oxide based material was made according to the invention. Another batch of Y₅Ba₆Cu₁₁O_{y} samples were made by a similar ceramic technique as Examples 1 and 2. Specifically, the unreacted powders were calcined at 930°C in O₂ for 12 hours. After subsequently grinding the reacted powder, this powder was heated at 950°C for 12 hours followed by a 10 hour-500°C heating in O₂ to ensure a dark black powder. This reacted powder was reground, pressed into a pellet at about 345 mPa (50,000 psi), sintered at 800°C for 24 hours in O₂, and quenched from 800°C to room temperature. Small pieces were cut from this pellet and then subjected to an additional sintering at 800°C for 24 hours in O₂, slowly cooled to 270°C, and quenched to room temperature.

This batch of samples was then placed in a high pressure vessel filled with (pure) oxygen to a pressure of 13 mPa (130 atmospheres) for the oxygenation process. After an oxygenation in the oxygen for 96 hours at 150°C and cooling back to room temperature over a period of several hours, these samples were removed from the vessel and placed inside an oxygen-filled desiccator under the conditions of that of Example 1.

Qualitative and quantitative results similar to those described above for the samples of Examples 1 and 2 were observed from electrical resistance and magnetisation measurements made of these high pressure oxygenated samples of this example. Current-voltage characteristics measurements were made (current parallel to direction of applied force associated with pressing of the pellet) as a function of temperature in order to determine the transition temperature. A zero-voltage current was clearly observed at 259 K in contrast to an ohmic behaviour at 305 K. Although the transition temperature for zero resistance varied over a 30 K temperature range depending on the bias current and thermal history, a zero resistance state above 220 K was maintained for several thermal cycles over a seven day period of time. The maximum zero-voltage current exceeded 40 mA at 240 K. Similar magnetisation behaviour as seen in Examples 1 and 2 was also observed, namely, diamagnetic-like deviations and hystereric behaviour occurring at temperatures correlating to the resistance drops.

### Example 4

In this example, a zero resistance copper oxide based material was made according to this invention. Samples were prepared according to a similar procedure as Example 1. Specifically, this batch of a nominal composition Y₅Ba₆Cu₁₁O_{y} was produced by calcining unreacted powders of Y₂O₃, BaCO₃, and CuO powders at 950°C for 12 hours in O₂ gas. After subsequent grinding the reacted powder, the powder was pressed into a pellet at about 345 mPa (50,000 psi), sintered at 950°C for 24 hours in O₂. The pellet was reground, pressed into another pellet at about 50,000 psi, sintered at 800°C for another 24 hours in O₂, and furnace-cooled to room temperature. Small pieces were cut from this pellet, then subjected to an additional sintering at 800°C for 27 hours in O₂ and cooled to 270°C before removing from the furnace.

These pieces were then placed in a high pressure vessel filled with (pure) oxygen to a pressure of 13 mPa (130 atmospheres) for the oxygenation process. After an oxygenation in the oxygen for 96 hours at 150°C and cooling back to room temperature over a period of several hours, these samples were removed from the vessel and placed inside an oxygen-filled desiccator under the conditions of that of Example 1.

Qualitative and quantitative results similar to those described above for the sample of Example 3 were observed from electrical resistance measurements made on one of these high-pressured oxygenated samples of this example. Current-voltage characteristics measurements were made (current parallel to direction of applied force associated with pressing of the pellet) as a function of temperature. The transition temperature with a zero-voltage current was determined to be 270 K ± 10 K when the sample was measured in an oxygen environment.

When the oxygen environment surrounding the sample was removed (i.e., a vacuum) at room temperature, the sample's normal-state resistance increased and the zero-resistance transition of 270 K disappeared, i.e., no zero-voltage current was detectable. This counter example indicates that the higher-T_{c} phase is related to the oxygenation at low temperatures and is unstable in a non-oxygen environment, i.e., a vacuum or even helium vapour.

## Claims

1. A method of making a copper oxide based material having a zero resistance transition temperature above 200 K which comprises forming an oxygenated multiphase copper oxide based material having the nominal composition Y₅Ba₆Cu₁₁0_{y} by calcining a corresponding precursor material and then subjecting it to a low temperature oxygenation in an atmosphere comprising at least 50% of oxygen by volume at a temperature less than 200°C.

2. A method according to claim 1 wherein the oxygenation is performed in an atmosphere comprising more than 95% oxygen by volume.

3. A method according to claim 1 or claim 2 wherein the oxygenation is performed at a temperature of at least 25°C.

4. A method according to any preceding claim wherein the oxygenation is performed in an atmosphere at a pressure of at least 0.1 Mpa (one atmosphere) for a period of greater than 5 days.

5. A method according to any preceding claim wherein the atmosphere is at a pressure of greater than 10 Mpa (100 atmospheres).

6. A method according to claim 5, wherein the oxygenation is performed at a temperature between 120 and 170°C.

7. A method according to any preceding claim wherein the oxygenated multiphase copper oxide material is enveloped with a coating substantially non-permeable to oxygen.

8. A method according to claim 7 wherein the coating comprises a gas-impervious ceramic coating.

9. A method according to claim 8 wherein the ceramic coating is aluminium oxide.

10. A method of maintaining the zero resistance transition property of the oxygenated multiphase copper oxide compound made by any of claims 1 to 6 which comprises surrounding it with an atmosphere comprising at least 50% oxygen by volume and maintaining it at a temperature less than 200°C.

11. A method according to claim 10 wherein the surrounding atmosphere comprises at least 95% oxygen by volume.

## Patentansprüche

1. Ein Verfahren zum Herstellen eines Materials auf Kupferoxidbasis mit einer Sprungtemperatur zum Nullwiderstand oberhalb von 200K, das das Bilden eines sauerstoffangereicherten, mehrphasigen Materials auf Kupferoxidbasis der Sollzusammensetzung Y₅Ba₆Cu₁₁O_{y} umfaßt, durch Kalzinieren eines entsprechenden Vorläufermaterials und dessen anschließendes Unterwerfen einer Sauerstoffanreicherung bei niedriger Temperatur in einer Atmosphäre, die mindestens 50 Volumenprozent Sauerstoff enthält, bei einer Temperatur unterhalb 200°C.

2. Ein Verfahren nach Anspruch 1, worin die Sauerstoffanreicherung in einer Atmosphäre, die mehr als 95 Volumenprozent Sauerstoff enthält, durchgeführt wird.

3. Ein Verfahren nach Anspruch 1 oder Anspruch 2, worin die Sauerstoffanreicherung bei einer Temperatur von mindestens 25°C durchgeführt wird.

4. Ein Verfahren nach irgendeinem der vorhergehenden Ansprüche, worin die Sauerstoffanreicherung in einer Atmosphäre bei einem Druck von mindestens 0.1 MPa (eine Atmosphäre) über einen Zeitraum von mehr als 5 Tagen durchgeführt wird.

5. Ein Verfahren nach irgendeinem der vorhergehenden Ansprüche, worin sich die Atmosphäre bei einem Druck von mehr als 10 MPa (100 Atmosphären) befindet.

6. Ein Verfahren nach Anspruch 5, worin die Sauerstoffanreicherung bei einer Temperatur von zwischen 120 und 170°C durchgeführt wird.

7. Ein Verfahren nach irgendeinem der vorhergehenden Ansprüche, worin das sauerstoffangereicherte, mehrphasige Material auf Kupferoxidbasis mit einem Belag umgeben wird, der im wesentlichen für Sauerstoff undurchlässig ist.

8. Ein Verfahren nach Anspruch 7, worin der Belag einen gasdichten keramischen Belag umfaßt.

9. Ein Verfahren nach Anspruch 8, worin der keramische Belag Aluminiumoxid ist.

10. Ein Verfahren zum Erhalten der Eigenschaft des Übergangs zum Nullwiderstand der sauerstoffangereicherten, mehrphasigen Kupferoxidverbindung, hergestellt mittels irgendeinem der Ansprüche von 1 bis 6, das deren Umgeben mit einer Atmosphäre umfaßt, die mindestens 50 Volumenprozent Sauerstoff enthält, und deren Aufbewahrung bei einer Temperatur unterhalb 200°C.

11. Ein Verfahren nach Anspruch 10, worin die umgebende Atmosphäre mindestens 95 Volumenprozent Sauerstoff umfaßt.

## Revendications

1. Procédé de fabrication d'un matériau à base d'oxyde de cuivre ayant une température de transition de résistance nulle supérieure à 200 K qui comprend la formation d'un matériau à base d'oxyde de cuivre à multiphase oxygénée ayant la composition nominale Y₅Ba₆Cu₁₁O_{y} en calcinant un matériau précurseur correspondant et en le soumettant ensuite à une oxygénation à faible température dans une atmosphère comprenant au moins 50 % d'oxygène en volume à une température inférieure à 200°C.

2. Procédé selon la revendication 1, dans lequel l'oxygénation est effectuée dans une atmosphère comprenant plus que 95 % d'oxygène par volume.

3. Procédé selon la revendication 1 ou 2, dans lequel l'oxygénation est effectuée à une température d'au moins 25°C.

4. Procédé selon l'une quelconque des revendications précédentes, dans lequel l'oxygénation est effectuée dans une atmosphère à une pression d'au moins 0,1 MPa (une atmosphère) pendant une durée de plus de 5 jours.

5. Procédé selon l'une quelconque des revendications précédentes, dans lequel l'atmosphère est à une pression de plus de 10 MPa (100 atmosphères).

6. Procédé selon la revendication 5, dans lequel l'oxygénation est effectuée à une température située entre 120 et 170°C.

7. Procédé selon l'une quelconque des revendications précédentes, dans lequel le matériau d'oxyde de cuivre à multiphase oxygénée est enveloppé d'un revêtement quasiment imperméable à l'oxygène.

8. Procédé selon la revendication 7, dans lequel le revêtement comprend un revêtement de céramique étanche au gaz.

9. Procédé selon la revendication 8, dans lequel le revêtement de céramique est l'oxyde d'aluminium.

10. Procédé pour maintenir la propriété de transition de résistance nulle du composé d'oxyde de cuivre à multiphase oxygénée préparé selon l'une quelconque des revendications 1 à 6 qui comprend le fait de l'entourer d'une atmosphère comprenant au moins 50 % d'oxygène par volume et en le maintenant à une température inférieure à 200°C.

11. Procédé selon la revendication 10, dans lequel l'atmosphère entourant comprend au moins 95 % d'oxygène par/en volume.
